Europäisches Patentamt

European Patent Office

Office européen des brevets

(19)

(11) Numéro de publication : **0 543 708 B1**

(12) **FASCICULE DE BREVET EUROPEEN**

(45) Date de publication du fascicule du brevet :
25.01.95 Bulletin 95/04

(51) Int. Cl.[6] : **H03F 3/45**

(21) Numéro de dépôt : **92403063.8**

(22) Date de dépôt : **13.11.92**

(54) **Amplificateur différentiel ultra-rapide.**

(30) Priorité : **22.11.91 FR 9114406**

(43) Date de publication de la demande :
**26.05.93 Bulletin 93/21**

(45) Mention de la délivrance du brevet :
**25.01.95 Bulletin 95/04**

(84) Etats contractants désignés :
**BE DE GB IT NL**

(56) Documents cités :
**EP-A- 0 264 160
PATENT ABSTRACTS OF JAPAN vol. 4, no. 67
(E-11)(549) 20 Mai 1980
PATENT ABSTRACTS OF JAPAN vol. 5, no. 70
(E-56)(742) 12 Mai 1981**

(73) Titulaire : **THOMSON-CSF
SEMICONDUCTEURS SPECIFIQUES
51, Esplanade du Général de Gaulle
F-Puteaux - La Défense 10 (FR)**

(72) Inventeur : **Grasset, Jean-Charles
THOMSON-CSF SCPI,
50, rue J.P. Timbaud
F-92400 Courbevoie Cedex (FR)**

(74) Mandataire : **Taboureau, James et al
THOMSON-CSF,
SCPI,
B.P. 329,
50, rue Jean-Pierre Timbaud
F-92402 Courbevoie Cédex (FR)**

EP 0 543 708 B1

## Description

La présente invention concerne un amplificateur différentiel ultra-rapide, réalisé en transistors bipolaires, ayant de bonnes caractéristiques dynamiques. Ces caractéristiques sont obtenues au moyen d'une contre-réaction positive en courant contrôlée.

On sait actuellement réaliser des amplificateurs opérationnels ayant des gains en boucle ouverte basse fréquence très élevés, jusqu'à 100 millions, associés à des tensions d'offset, c'est à dire de décalage, très faibles, quelques microvolts ou dizaines de microvolts.

La contre-partie de ces caractéristiques intéressantes est supportée par les performances dynamiques : le produit gain-bande ou fréquence de transmission $F_T$ n'excède pas quelques dizaines de mégahertz, et la vitesse de balayage, plus connue sous sa désignation anglaise "slew rate", reste intrinsèquement limitée à quelques dizaines de volts par microseconde, sauf avec des technologies très sophistiquées et donc coûteuses.

Cette détérioration des performances dynamiques provient de la présence dans l'amplificateur d'une capacité C de compensation qui détermine la stabilité en créant un pôle dominant, qui diminue la fréquence de transition, et en limitant le slew-rate à I/C, I étant le courant de polarisation de l'étage d'entrée.

L'amplification de signaux rapides avec restitution de la composante continue dont on a besoin dans certaines applications du traitement du signal, tel que amplificateurs vidéo, amplificateurs d'impulsions, échantillonneurs bloqueurs rapides etc... ne peut donc pas être résolue par ce type de composant.

Dans le cadre de ces applications, il faut au contraire des amplificateurs à très large bande passante (quelques 100 MHz) et à slew-rate très élevé (quelques 100V/μs) pour amplifier sans déformation les signaux rapides. La précision requise en continu est généralement plus modérée (1/100 ou 1/1000) et un offset en tension de quelques millivolts est généralement toléré.

Les solutions apportées à ces difficultés par l'art connu ressortent de trois catégories. Dans la première, les structures dérivées de la technique traditionnelle des amplificateurs opérationnels s'appuyant sur des technologies à isolation diélectrique. Ces solutions ne permettent pas d'atteindre les slew-rates les plus élevés.

La seconde comprend des structures basées sur les techniques d'amplificateurs large bande non rebouclés. L'absence de contre-réaction globale élimine les capacités de compensation. Ces amplificateurs non contre-réactionnés sont intrinsèquement les plus rapides, ceux qui permettent de s'approcher des limites de vitesse de la technologie. Toutefois la restitution de la composante continue est très délicate parce qu'elle repose sur une technique de compensation des décalages continus apportés par les étages successifs. Toujours approximative, cette méthode est très sujette aux dérives en température et ne donne pas de résultats satisfaisants, notamment à cause de l'augmentation du nombre de composants qu'il faut introduire pour rattraper le niveau continu.

La troisième catégorie comprend les amplificateurs dont le grand gain est obtenu par une contre-réaction positive en tension. Le signal de sortie n'est disponible que sous haute impédance, ce qui rend le circuit sensible, en stabilité, aux charges capacitives. En outre, ces circuits ont une moindre marge de phase naturelle, ce qui rend nécessaire une légère compensation, d'où une moindre bande passante, un slew-rate diminué et rend délicat, dans certains cas, le rebouclage en suiveur.

L'invention apporte une solution différente, qui permet à un amplificateur différentiel d'avoir à la fois un grand gain, une fréquence de coupure élevée et un important slew-rate. Selon l'invention, à un amplificateur différentiel classique, à charges résistives, est adjoint un circuit de réaction (ou contre-réaction positive) en courant dont le gain de boucle, inférieur à l'unité, est contrôlé de manière à garantir la stabilité de l'ensemble. Les résistances de charge sont connectées entre le pôle de l'alimentation et les sorties de l'amplificateur différentiel, mais elles sont également montées en parallèle avec deux sources de courant qui exercent leur réaction en courant sur les sorties.

De façon plus précise, l'invention selon la revendication 1 concerne un amplificateur différentiel ultra-rapide, à gain élevé, constitué par deux branches formées chacune par au moins un dispositif semiconducteur et une unique résistance de charge, cet amplificateur étant caractérisé en ce que, en vue de lui conférer un produit gain-bande élevé, il est muni d'une contre-réaction positive en courant contrôlée, constituée, pour chaque branche, par un générateur de courant qui tire un courant à travers la résistance de charge de la dite branche, en phase avec celui issu du dispositif semiconducteur sur lequel est branchée la résistance, chaque générateur étant connecté entre le point commun au dispositif semiconducteur et à la résistance de charge correspondante, et une source de tension.

L'invention sera mieux comprise par la description plus détaillée d'un exemple d'application, cette description étant faite en liaison avec les figures jointes en annexe, qui représentent :

- figure 1 : schéma électrique d'un amplificateur différentiel selon l'art connu,
- figure 2 : schéma simplifie d'un amplificateur différentiel selon l'invention,
- figure 3 : schéma détaillé de l'amplificateur de la figure précédente,
- figure 4 : variante de l'amplificateur de la figure 3,
- figure 5 à 9 : courbes de caractéristiques dynamiques obtenues avec l'amplificateur selon l'invention.

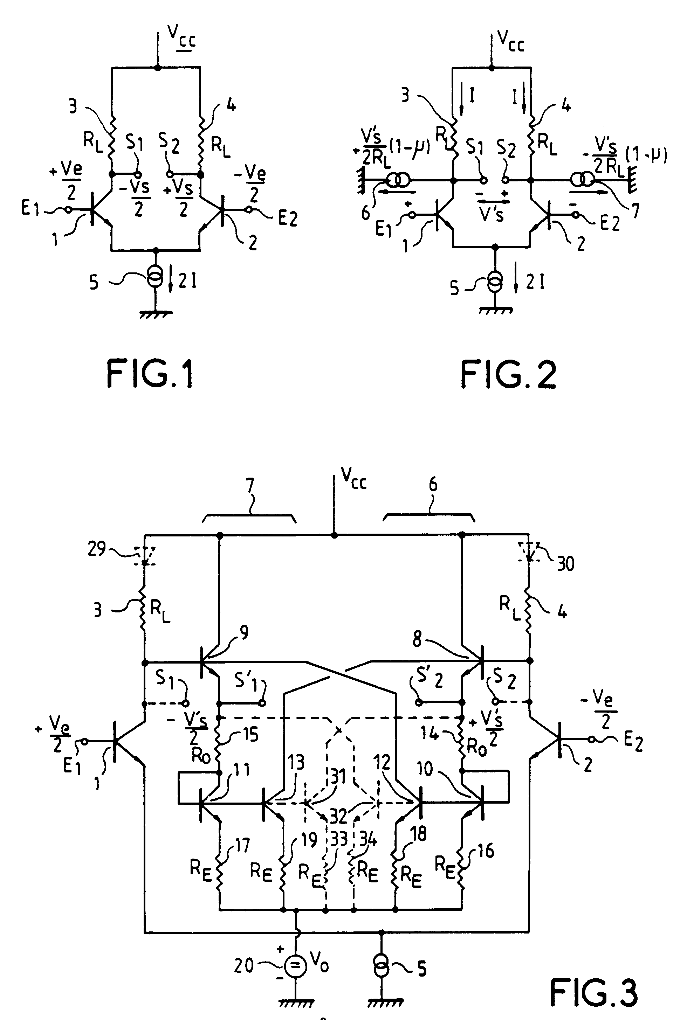

La figure 1 représente le schéma simplifié d'un amplificateur différentiel, et a pour objectif de faciliter la comparaison avec un amplificateur selon l'invention. Dans sa plus simple expression, un amplificateur différentiel comprend deux transistors 1 et 2, dont les bases servent de bornes d'entrées. Les bornes de sorties sont prises sur les collecteurs de ces transistors qui sont chargés par deux résistances de charge 3 et 4, reliées à un premier pôle $V_{cc}$ d'une alimentation. Les émetteurs des transistors 1 et 2 sont reliés au second pôle de cette alimentation, à travers une source de courant 5 qui débite un courant 2I.

Si l'on appelle $v_e$ la tension d'entrée et $v_s$ la tension de sortie d'un amplificateur, dans le cas où cet amplificateur est de type différentiel il est alors habituel d'affecter ses deux entrées d'une tension $\pm v_e/2$ et ses deux sorties d'une tension $v_s/2$.

Les résistances de charge 3 et 4 ont une valeur $R_l$ et le gain dynamique de cet amplificateur est :
$$G = v_s / v_e \simeq R_L I/U_t$$
dans lequel $U_t$ = potentiel thermodynamique
$$U_t = k\, T/q = 26 \text{ mV à } 300°\,K$$
(k = cste de Boltzmann , T = température, q = charge de l'électron).

Sur la figure 2, qui donne le fondement d'un amplificateur selon l'invention, il apparaît que la structure de l'amplificateur de départ est inchangée, mais que sur chacune des sorties est ajouté un générateur de courant 6 ou 7, qui tire un courant $\pm v'_s (1 - \mu)/2\, R_L$ à travers chacune des résistances de charge 3 ou 4, $\mu$ étant l'erreur de recopie, avec $\mu \ll 1$. Ainsi, la réaction est obtenue en pilotant chacune des résistances par un courant additionnel en phase avec celui issu du transistor de la paire d'entrée sur lequel la dite résistance est connectée. Sur chaque branche de l'amplificateur différentiel, le générateur de courant 6 ou 7 et le collecteur du transistor 1 ou 2 sont réunis à un première borne de l'unique résistance de charge 3 ou 4, dont une deuxième borne est réunie au premier pôle $V_{cc}$ de l'alimentation. Pour simplifier, on supposera que le transistor 1 constitue l'entrée positive: le générateur 6 tire un courant positif en phase avec celui issu du transistor 1. Et symétriquement, le générateur 7 tire un courant négatif, en phase avec celui issu du transistor 2.

L'erreur de recopie $\mu$ permet de contrôler le facteur multiplicatif apporté par cette réaction par rapport au gain classique G :
$$G' = v'_s / v_e \simeq R_L I /\mu\, U_t$$
soit :
$$G' = G/\mu$$
On peut considérer qu'en première approximation on simule une charge fictive $R_L /\mu$ ou une transconductance fictive $g'm = gm/\mu\quad gm = I/U_t$.

La figure 3 donne une schéma électrique plus détaillé de cet amplificateur à contre-réaction positive en courant, contrôlée. Tous les transistors sont de type NPN. Toutefois ne sont pas représentés sur cette figure les étages de sorties, qui sortent du domaine de l'invention.

Le squelette de l'amplificateur différentiel est constitué des transistors 1 et 2 et des résistances 3 et 4, ainsi que du générateur de courant 5, comme précédemment.

Le générateur 6 de courant de contre-réaction est constitué par un miroir de courant formé par les transistors 10 et 12 et le transistor 8 qui focntionne en suiveur de tension.

Le transistor 8 a sa base connectée au point commun entre la résistance de charge 4 et le collecteur du transistor 2, c'est-à-dire sur la sortie $S_2$ de l'amplificateur.

Une résistance 14, de valeur $R_o$, est connectée entre l'émetteur du transistor 8 et la collecteur du transistor 10. De même, deux résistances 16 et 18, de valeur $R_E$, sont connectées entre les émetteurs des transistors 10 et 12, et une source de tension 20, sur laquelle on reviendra . Ces résistances 16 et 18 sont des résistances de dégénérescence, pour diminuer le facteur de bruit de l'amplificateur, et sont choisies telles que :
$$R_o + R_E = R_L$$
On sait qu'un miroir de courant peut avoir deux sources d'alimentations différentes pour ses deux branches. La première branche de ce miroir (transistors 8 et 10) est alimenté à partir de la source $V_{cc}$ commune à l'amplificateur différentiel. La seconde branche (transistor 12) est alimentée à partir du point commun à la résistance de charge 3 et au collecteur du transistor d'entrée 1, ce qui revient à dire que la deuixème branche du générateur 6 est connectée sur la sortie $S_1$ de l'amplificateur différentiel.

Par conséquent, le transistor suiveur 8 suit la tension sur la sortie $S_2$ de l'amplificateur, engendrant des variations de courant proportionnelles dans $R_o$ qui sont recopiées par le miroir 10 + 12 en $S_1$ : le générateur 6 tire un courant à travers la résistance de charge 3, et il agit bien comme un générateur de courant qui exerce une réaction positive en courant contrôlée.

Le même raisonnement s'applique au générateur 7, après transposition aux transistors 9,11, et 13 et aux résistances 15,17 et 19, pour la seconde branche de l'amplificateur différentiel.

Il faut remarquer que, sur la figure 3, l'amplificateur différentiel comporte 4 sorties. Les sorties $S_1$ et $S_2$, sur les collecteurs des transistors d'entrées 1 et 2, sont les sorties "normales" d'un amplificateur, mais il est préférable de choisir les sorties $S'_1$ et $S'_2$ sur les émetteurs des transistors 8 et 9 de l'amplificateur de réaction, car ces transistors servent d'adaptateurs d'impédances naturels du montage sans apporter de déphasage supplémentaire.

L'ensemble des deux générateurs 6 et 7 constitue un amplificateur à transconductance commandé par la tension différentielle $S_1$ - $S_2$ qui débite dans les charges 3 et 4 opposées.

La transconductance vaut au premier ordre :

$$1/(R_o + R_E + 2 r_{eo}) = 1/(R_L + 2r_{eo})$$

Le gain en tension de cette réaction obtenue par débit dans les charges $R_L$ vaut:

$$R_L /(R_L + 2r_{eo}) \simeq 1 - 2r_{eo} / R_L$$

de la forme $(1-\mu)$ avec $\mu = 2r_{eo}/R_L \ll 1$ avec $r_{eo} = U_t/I$ pour les transistors 10 et 8.

On définit ainsi en le contrôlant le facteur multiplicatif d'amplification $1/\mu$.

Le générateur 20 de tension Vo offre un éventuel degré de liberté supplémentaire dans le choix des paramètres dynamiques et statiques. On peut prendre Vo = 0.

La valeur du facteur multiplicatif $1/\mu$ dépendant au premier ordre du rapport $\mu = 2r_{eo}/R_L$, où $r_{eo}$ représente l'impédance dynamique d'émetteur des transistors 8 et 10 (9 et 11), il peut être intéressant de la multiplier par 2 de deux manières différentes :

- soit en insérant suivant une méthode annexe une diode 29 (30) en série avec la charge 3 (4) à la condition que l'on choisisse grâce à $V_o$, des courants de repos dans 8 et 9 égaux à ceux de 1 et 2 c'est à dire I.
- Soit en annulant l'une des deux impédances dynamiques $r_{eo}$ constitutives de $\mu = 2 r_{eo}/R_L$, en l'occurence celles de 8 et 9.

Ceci est obtenu par l'adjonction d'une sortie supplémentaire sur chaque miroir, grâce aux transistors 31 et 32, et leurs résistances de dégérescence associées 33,34 la sortie de 31 (32) étant connectée à l'émetteur de 8 (9).

Les courants qui circulent dans 32 et 9 (31 et 8) étant en opposition de phase et de même amplitude au premier ordre on annule par ce procédé l'impédance dynamique 20 des transistors.

Par ailleurs, dans ceetains cas particuliers il peut être intéressant de remplacer le miroir élémentaire utilisé dans le circuit de réaction (10,12 et 11,13) par une structure de miroir plus élaborée telle qu'un miroir "bufférisé" ou de Wilson connus de l'état de l'art.

La solution présentée en figures 2 et 3 ne présume pas de la nature du dispositif transconducteur d'entrée.

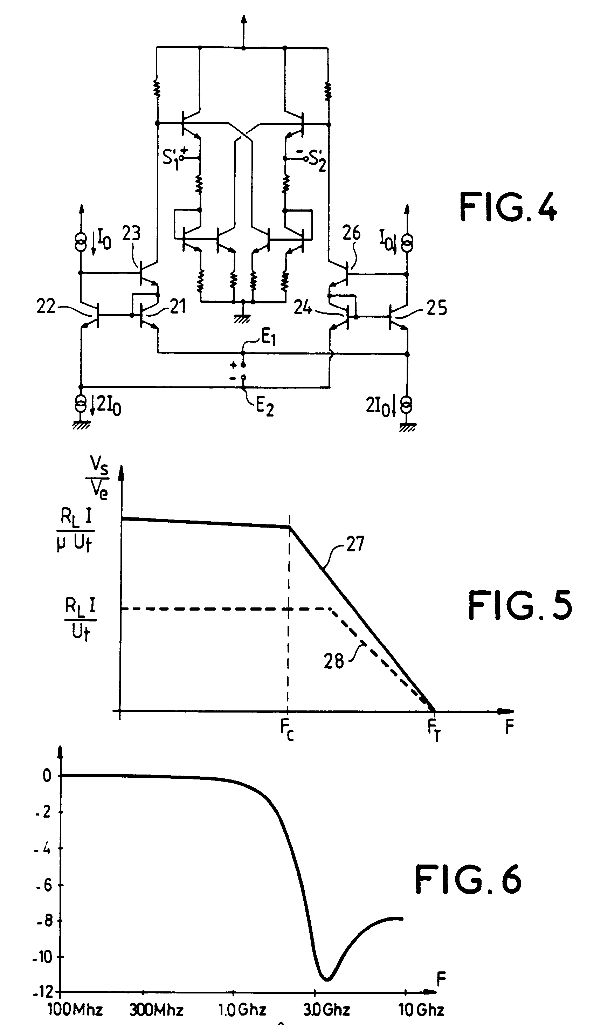

On peut également envisager un transducteur d'entrée construit autour de deux miroirs attaqués par les émetteurs et non plus par les bases, comme représenté en figure 4. Cette approche confère à l'ensemble une structure d'amplificateur à transimpédance compte tenu de sa faible impédance d'entrée.

Cette solution a été mise en oeuvre sur le montage dérivé "à transimpédance" en utilisant des miroirs simples ou des miroirs de type Wilson qui assurent le cascodage des transistors d'entrée, 21 et 25 pour l'entré $E_1$ et 22 et 24 pour l'entrée $E_2$ de la figure 4.

On obtient un gain de boucle ouverte de 75 dB. Le corrolaire de cette amélioration par complexification réside dans la réponse en fréquence dégradée. Un deuxième pôle apparaissant dans la bande oblige à un légère compensation réduisant la bande maximum utile, en fonctionnement suiveur, à une valeur inférieure au gigahertz.

Les amplificateurs différentiels selon l'invention sont remarquables par leur simplicité de structure, qui leur confère leurs performances.

Le gain de ces amplificateurs est réalisé en un seul étage avec un pôle dominant situé sur la sortie différentielle S1-S2. Mis à part le pôle d'un suiveur de sortie supplémentaire dont on peut négliger la déphasage dans un premier temps, aucun deuxième étage ne vient apporter de rotation de phase significative qui obligerait à construire un pôle dominant entre S1 et S2.

La réponse en fréquence de l'étage est excellente et assez peu différente de la réponse en fréquence de l'étage différentiel classique à charges résistives. Seul le gain BF est augmenté. Pratiquement on peut obtenir des fréquences de transition (0 dB, marge de phase 35° à 45°) voisines de Ft/2 où Ft est la fréquence de transition des transistors, comme le montre la figure 5 qui représente la réponse en fréquence F en fonction du gain en boucle ouverte, pour un amplificateur selon l'invention (27) comparé à un amplificateur classique différentiel (28).

Cette qualité de réponse globale provient de la qualité de réponse de l'amplificateur de réaction dont le gain faible $(1-\mu)$ s'accompagne d'un produit gainbande élevé et d'un déphasage modeste. On conserve le bénéfice de la fréquence de transition élevée du montage classique à charge résistive, qui est l'amplificateur linéaire le plus rapide que l'on connaisse, et on lui adjoint la caractéristique fondamentale des amplificateurs opérationnels : un grand gain en continu, 60 à 70 dB.

La rotation de phase modeste qui accompagne la chute de gain de boucle jusque vers 0 dB ne nécessite pas ou très peu de capacité de compensation entre les noeuds S1 et S2. Comme ce type d'étage est polarisé à des courants relativement élevés, quelques centaines de $\mu A$, en comparaison de ceux qu'on observe traditionnellement sur les étages d'entrée d'amplificateurs opérationnels, il s'en suit des slewrates extrêmement élevés, ce courant fort n'ayant à charger ou décharger pratiquement que des capacités parasites.

En ce qui concerne le bruit, l'absence de vraie charge active dans le montage permet de retrouver des densités spectrales de bruit thermique voisines de celles obtenues sur les amplificateurs large bande, faible gain, des applications UHF de l'ordre de quelques nanovolts par racine de hertz. La caractéristique très remarquable est la platitude de la densité spectrale de bruit jusqu'à la fréquence de transition de l'amplificateur.

Enfin, il faut remarquer que la sortie de l'amplificateur selon l'invention est intrinsèquement différentielle, par structure, ce qui lui confère un gros avantage du point de vue qualité du traitement de signal, surtout compte tenu de la très large bande passante qu'il offre. Le taux de réjection des alimentations dans le traitement de signal global s'en trouvera amélioré. Il faut noter que le fait de travailler en différentiel fait gagner 6 dB sur le gain de boucle par rapport à une sortie simple et presqu'une octave sur la fréquence de transition mesurée à 0dB.

Les figures suivantes donnent les performances de circuits basés sur une technologie rapide :
- $F_T$ des transistors = 8 GHz
- tension d'Early = 33 volts
- résistance de charge $R_L$ = 16 K ohms
- Courant de polarisation 2 X 250 µ ampères.

La figure 6 représente la réponse en fréquence (atténuation en ordonnées) de l'amplificateur selon l'invention, bouclé en suiveur. Dans un montage en sortie différentielle, on obtient un produit gain-bande de 4,5 GHz, avec une marge de phase naturelle, sans compensation, de 40 °.

Un autre avantage, du point de vue de la réponse en fréquence, est la possibilité d'exploiter le signal de sortie à relativement faible impédance. En effet, les signaux de sortie sont naturellement bufférisés par les suiveurs de l'amplificateur de réaction (8+9) et sortent donc sous une impédance diminuée par le gain des transistors.

L'intérêt est évident du point du vue de la réponse sur charge capacitive qui, après adjonction de suiveurs de sortie, permet de conserver un produit gain-bande de 2.4 GHz (marge de phase 45°) sur une charge de 10 pF.

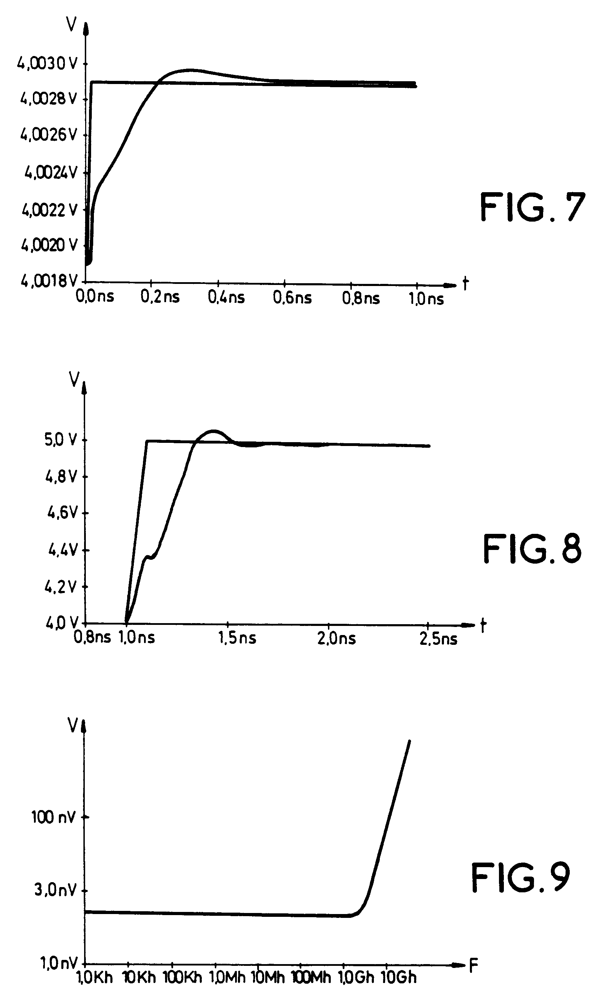

Pour le même amplificateur, la figure 7 donne la réponse implusionnelle : pour une impulsion de 1 mV, on obtient un temps de réponse $t_r$ < 200 psec, en accord avec la bande passante.

La vitesse de balayage, ou slew-rate, est représentée en figure 8. Avec la technologie et les valeurs de polarisation indiquées précédemment, on obtient des slew-rates supérieurs à 1 KV/µs. En augmentant les courants de repos, avec des résistances plus faibles et des géométries de transistors minimum, si on accepte de dégrader les performances en bruit, on obtient des slew-rates jusqu'à 4 KV/µs, les performances de bande passante sont alors légèrement améliorées.

Ces slew-rates ont été mesurés dans la configuration classique du montage suiveur non-inverseur.

Les valeurs de slew-rates indiquées içi sont celles relatives à la structure intrinsèque de l'amplificateur. Dans le cas particulier du fonctionnement sur charge capacitive significative (10 pF), le slew-rate est essentiellement limité à la descente par le générateur de courant de polarisation du suiveur de sortie supplémentaire classe A, intercalé aprés cet étage.

Bien qu'on connaisse des solutions alternatives pour accroître ce slew-rate dans ces conditions particulières de fonctionnement, elles dégradent inévitablement la bande passante de l'amplificateur qui devient alors inférieure au gigahertz.

Enfin, la figure 9 donne la densité spectrale de bruit d'entrée, en nV/√Hz, en fonction de la fréquence. Dans les conditions de polarisations indiquées, ce bruit de l'ordre de 2,7 nV/√Hz est quasiment plat jusqu'à la fréquence de transition de l'amplificateur.

L'amplificateur différentiel selon l'invention a donc de bonnes caractéristiques dynamiques, et simultanément un grand gain. Avec les valeurs de polarisations citées, son gain de boucle ouverte, en sortie différentielle, est de 60 dB.

La limitation principale de la valeur du gain BF est la valeur de la tension d'Early des transistors amplificateurs de la paire d'entrée, 1 et 2. Un procédé classique pour tourner cette difficulté consiste à cascoder le montage ce qui permet de gagner entre 10 et 15 dB sur la valeur du gain de boucle. C'est le type de montage représenté en figure 4.

L'amplificateur différentiel selon l'invention est utilisé dans les montages qui nécessitent à la fois un grand gain et de bonnes performances dynamiques, dans une large bande passante : par exemple un multiplexeur analogique ultra-rapide, ou un échantillonneur bloqueur.

## Revendications

1. Amplificateur différentiel ultra-rapide, à gain élevé, constitué par deux branches formées chacune par au moins un dispositif semiconducteur (1,2) et une unique résistance de charge (3,4), muni d'une contre-réaction positive en courant contrôlée, constituée, pour chaque branche, par un générateur de courant (6,7) qui tire un courant à travers la résistance de charge (3,4) de la dite branche, chaque générateur étant connecté entre le point commun au dispositif semiconducteur (1,2) et à la résistance de charge (3,4) correspondante et une source de tension (20), cet amplificateur étant caractérisé en ce que chacun des générateurs de courant (6,7) est constitué par un miroir de courant dont la sortie (12,13) est connectée sur le point commun (S1,S2) à la résistance de charge (3,4) et au transistor (1,2) et dont l'entrée est constituée par un transistor (10,11) alimenté en courant par une résistance (14,15) connectée à l'émetteur d'un suiveur (8,9) dont la base est alimentée par la sortie (S2,S1) de la branche opposée à celle dans laquelle ledit générateur de courant débite.

2. Amplificateur selon la revendication 1, caractérisé en ce que le dispositif semiconducteur de chaque branche est un miroir de courant, simple ou de Wilson, constitué d'au moins deux transistors (21,22) (24,25), une première entrée ($E_1$) de l'amplificateur étant connectée sur les émetteurs d'un premier transistor (21) du premier miroir et d'un second transistor (25) du second miroir et une deuxième entrée ($E_2$) de l'amplificateur étant connectée sur les émetteurs d'un second transistor (22) du premier miroir et d'un premier transistor (24) du second miroir.

3. Amplificateur selon la revendication 1, dans lequel une sortie supplémentaire (31,32) est ménagée sur chaque miroir de courant, qui vient débiter dans l'émetteur du transistor suiveur (8,9) augmentant aussi le facteur d'amplification $1/\mu$.

4. Amplificateur selon la revendication 1 dans lequel une diode (30,29) est connectée en série avec la résistance de charge (4,3) et l'alimentation VCC.

5. Amplificateur selon la revendication 1, caractérisé en ce que chaque miroir de courant est constitué par un miroir de courant de type bufférisé ou de type Wilson.

6. Amplificateur selon la revendication 1, caractérisé en ce que des résistances (16 à 19) sont connectées sur les émetteurs des transistors (10 à 13), en vue de diminuer le facteur de bruit de l'amplificateur.

7. Amplificateur selon la revendication 1 caractérisé en ce qu'une source additionnelle de tension (20) est connectée sur les générateurs de courant (6,7), en vue de régler indépendamment les paramètres statiques et/ou dynamiques des générateurs de courants (6,7).

8. Amplificateur selon la revendication 1, caractérisé en ce que les sorties ($S'_1$, $S'_2$) de l'amplificateur sont prises sur les émetteurs des transistors suiveurs (8,9) des générateurs de courant (6,7) les dits transistors (8,9) servant d'adaptateurs d'impédances de sorties.

**Patentansprüche**

1. Ultraschneller Differentialverstärker mit hohem Verstärkungsgrad, bestehend aus zwei Zweigen, die je von mindestens einer Halbleitervorrichtung (1, 2) und einem einzigen Lastwiderstand (3, 4) gebildet werden, wobei der Verstärker eine positive kontrollierte Stromrückkopplung enthält, die für jeden Zweig aus einem Stromgenerator (6, 7) besteht, der einen Strom über den Lastwiderstand (3, 4) dieses Zweigs zieht, wobei jeder Generator zwischen dem gemeinsamen Punkt der Halbleitervorrichtung (1, 2) und des entsprechenden Lastwiderstands (3, 4) und einer Spannungsquelle (20) liegt, dadurch gekennzeichnet, daß jeder Stromgenerator (6, 7) aus einem Stromspiegel besteht, dessen Ausgang (12, 13) an den gemeinsamen Punkt (S1, S2) des Lastwiderstands (3, 4) und des Transistors (1, 2) angeschlossen ist und dessen Eingang von einem Transistor (10, 11) gebildet wird, der über einen Widerstand (14, 15) gespeist wird, welcher an den Emitter einer Folgeschaltung (8, 9) angeschlossen ist, deren Basis vom Ausgang (S2, S1) des entgegengesetzten Zweigs zu dem gespeist wird, in den der Stromgenerator seinen Strom liefert.

2. Verstärker nach Anspruch 1, dadurch gekennzeichnet, daß die Halbleitervorrichtung jedes Zweigs ein Stromspiegel ist, der vom einfachen oder vom Wilson-Typ ist und aus mindestens zwei Transistoren (21, 22) (24, 25) gebildet wird, wobei ein erster Eingang (E1) des Verstärkers an die Emitter eines ersten Transistors (21) des ersten Spiegels und eines zweiten Transistors (25) des zweiten Spiegels und ein zweiter Eingang ($E_2$) des Verstärkers an die Emitter eines zweiten Transistors (22) des ersten Spiegels und eines ersten Transistors (24) des zweiten Spiegels angeschlossen ist.

3. Verstärker nach Anspruch 1, in dem ein zusätzlicher Ausgang (31, 32) an jedem Stromspiegel vorgesehen ist, der Strom in den Emitter des als Folgeschaltung arbeitenden Transistors (8, 9) liefert und auch den Verstärkungsgrad $1/\mu$ erhöht.

4. Verstärker nach Anspruch 1, in dem eine Diode (30, 29) in Reihe mit dem Lastwiderstand (4, 3) und der Spannungsquelle $V_{cc}$ liegt.

5. Verstärker nach Anspruch 1, dadurch gekennzeichnet, daß jeder Stromspiegel aus einem Stromspiegel vom gepufferten oder vom Wilson-Typ besteht.

6. Verstärker nach Anspruch 1, dadurch gekennzeichnet, daß Widerstände (16 bis 19) an die Emitter der Transistoren (10, 13) angeschlossen sind, um den Rauschfaktor des Verstärkers zu verringern.

7. Verstärker nach Anspruch 1, dadurch gekennzeichnet, daß eine zusätzliche Spannungsquelle (20) an die Stromgeneratoren (6, 7) angeschlossen ist, um die statischen und/oder dynamischen Parameter der Stromgeneratoren (6, 7) unabhängig voneinander zu regeln.

8. Verstärker nach Anspruch 1, dadurch gekennzeichnet, daß die Ausgänge (S'$_1$, S'$_2$) des Verstärkers an den Emittern der Folgeschaltungstransistoren (8, 9) der Stromgeneratoren (6, 7) liegen, wobei diese Transistoren (8, 9) als Ausgangsimpendanz-Anpassungsorgane wirken.

## Claims

1. Ultra-fast differential amplifier, with high gain, consisting of two branches each formed by at least one semiconductor device (1,2) and a single load resistor (3,4), equipped with controlled, positive, current feedback, consisting, for each branch, of a current generator (6,7) which draws a current through the load resistor (3,4) of the said branch, each generator being connected between the point common to the semiconductor device (1,2) and to the corresponding load resistor (3,4) and a voltage source (20), this amplifier being characterized in that each of the current generators (6,7) consists of a current mirror the output (12,13) of which is connected to the point common (S1,S2) to the load resistor (3,4) and to the transistor (1,2), and the input of which consists of a transistor (10,11) fed with current by a resistor (14,15) connected to the emitter of a follower (8,9) the base of which is fed by the output (S2,S1) of the branch opposite that into which the said current generator delivers.

2. Amplifier according to Claim 1, characterized in that the semiconductor device of each branch is a simple or Wilson current mirror, consisting of at least two transistors (21,22) (24,25), a first input (E$_1$) of the amplifier being connected to the emitters of a first transistor (21) of the first mirror and of a second transistor (25) of the second mirror and a second input (E$_2$) of the amplifier being connected to the emitters of a second transistor (22) of the first mirror and of a first transistor (24) of the second mirror.

3. Amplifier according to Claim 1, in which an additional output (31,32) is formed on each current mirror, which delivers into the emitter of the following transistor (8,9) thus increasing the amplification factor 1/μ.

4. Amplifier according to Claim 1, in which a diode (30,29) is connected in series with the load resistor (4,3) and the power supply VCC.

5. Amplifier according to Claim 1, characterized in that each current mirror consists of a buffered-type or Wilson-type current mirror.

6. Amplifier according to Claim 1, characterized in that resistors (16 to 19) are connected on the emitters of the transistors (10 to 13), with a view to reducing the noise factor of the amplifier.

7. Amplifier according to Claim 1, characterized in that an additional voltage source (20) is connected to the current generators (6,7), with a view to independently setting the static and/or dynamic parameters of the current generators (6,7).

8. Amplifier according to Claim 1, characterized in that the outputs (S'$_1$, S'$_2$) of the amplifier are taken on the emitters of the follower transistors (8,9) of the current generators (6,7), the said transistors (8,9) serving as output impedance matchers.

FIG.1

FIG.2

FIG.3

8

FIG.4

FIG.5

FIG.6

EP 0 543 708 B1

# FIG. 7

# FIG. 8

# FIG. 9

10